(19)

Europäisches
Patentamt
European
Patent Office
Office européen
des brevets

(11) **EP 3 211 735 A1**

(12) **EUROPEAN PATENT APPLICATION**

(43) Date of publication:
**30.08.2017 Bulletin 2017/35**

(21) Application number: **17154453.9**

(22) Date of filing: **02.02.2017**

(51) Int Cl.:
*H01S 5/022* (2006.01)    *H01S 5/42* (2006.01)
*F02P 23/04* (2006.01)    *H01S 3/06* (2006.01)
*H01S 3/094* (2006.01)    *H01S 3/0941* (2006.01)
*H01S 5/00* (2006.01)    *H01S 5/024* (2006.01)
*H01S 5/40* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority:  **25.02.2016   JP 2016034381
16.11.2016   JP 2016223425**

(71) Applicant: **Ricoh Company, Ltd.
Tokyo 143-8555 (JP)**

(72) Inventor: **KIYOSAWA, Yoshiyuki
Tokyo 143-8555 (JP)**

(74) Representative: **J A Kemp
14 South Square
Gray's Inn
London WC1R 5JJ (GB)**

(54) **LIGHT SOURCE UNIT, LIGHT SOURCE MODULE, AND LASER IGNITION SYSTEM**

(57)    A light source unit (10), a light source module
(100), and a laser ignition device (100). The light source
unit (10) includes a lens array (23) including a plurality
of two-dimensionally disposed lenses (25) and a lens substrate portion (26) that supports the plurality of lenses
(25), and an element substrate portion (22) that supports
a plurality of light emitters (21). The element substrate
portion (22) has a second coefficient of liner expansion.
The first coefficient of linear expansion is approximately
same as the second coefficient of linear expansion of the
element substrate portion (22). The light source module
(100) includes the light source unit (10), and a condenser
lens (20, 33, 50) configured to collect and condense
pump light emitted from the light source unit (10). The
laser ignition device (100) includes the light source mod-
ule (100), and a laser resonator (40) configured to absorb
the pump light emitted from the light source unit (10).

FIG. 1A

EP 3 211 735 A1

**Description**

BACKGROUND

Technical Field

Embodiments of the present disclosure relate to a light source unit, a light source module, and a laser ignition system.

Background Art

Light source units where a plurality of lenses are arranged so as to face optical elements are known in the art (see, for example, JP-2014-192166-A and JP-H06-194502-A). The optical elements in such a configuration emit or receive light, and the lenses face the optical elements so as to improve the utilization efficiency of light from the optical elements.
In a lens array used for such light source units, the utilization efficiency of light deteriorates when the relative positions of the optical elements and the lenses that make up the lens array become misaligned. For this reason, the light source units known in the art are not suitable for the use under high-temperature situations, especially under the environment that is externally heated.

SUMMARY

Embodiments of the present disclosure described herein provide a light source unit, a light source module, and a laser ignition device. The light source unit includes a lens array including a plurality of two-dimensionally disposed lenses and a lens substrate portion that supports the lenses, and an element substrate portion that supports a plurality of light emitters. The element substrate portion has a second coefficient of liner expansion. The first coefficient of linear expansion is approximately same as the second coefficient of linear expansion of the element substrate portion. The light source module includes the light source unit, and a condenser lens configured to collect and condense pump light emitted from the light source unit. The laser ignition device includes the light source module, and a laser resonator configured to absorb the pump light emitted from the light source unit.
According to one aspect of the present disclosure, even under high ambient temperature conditions, the precision can be prevented from decreasing.

BRIEF DESCRIPTION OF THE DRAWINGS

A more complete appreciation of exemplary embodiments and the many attendant advantages thereof will be readily obtained as the same becomes better understood by reference to the following detailed description when considered in connection with the accompanying drawings.

FIG. 1A is a diagram illustrating a schematic configuration of a laser ignition system according to a first embodiment of the present disclosure.
FIG. 1B is a magnified view of a laser ignition device according to the present embodiment.
FIG. 2 is a plan view of a laser-beam source unit illustrated in FIG. 1A and FIG. 1B, according to an embodiment of the present disclosure.
FIG. 3 is a plan view of an optical transmission path illustrated in FIG. 1, according to an embodiment of the present disclosure.
FIG. 4 is a plan view of an optical amplifier illustrated in FIG. 1, according to an embodiment of the present disclosure.
FIG. 5A, FIG. 5B, FIG. 5C, and FIG. 5D are schematic diagrams of the process of forming microlenses, according to an embodiment of the present disclosure.
FIG. 6 is a flowchart of a method of manufacturing microlenses, according to an embodiment of the present disclosure.
FIG. 7 is a plan view of a microlens unit according to a related art.
FIG. 8 is a plan view of the impact of thermal expansion in the related art illustrated in FIG. 7.
FIG. 9 is a diagram illustrating the displacement of focal points due to the thermal expansion illustrated in FIG. 8.
FIG. 10A and FIG. 10B are schematic diagrams of microlenses according to a modification.

The accompanying drawings are intended to depict exemplary embodiments of the present disclosure and should not be interpreted to limit the scope thereof. The accompanying drawings are not to be considered as drawn to scale unless explicitly noted.

DETAILED DESCRIPTION

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

In describing example embodiments shown in the drawings, specific terminology is employed for the sake of clarity. However, the present disclosure is not intended to be limited to the specific terminology so selected and it is to be understood that each specific element includes all technical equivalents that have the same structure, operate in a similar manner, and achieve a similar result.

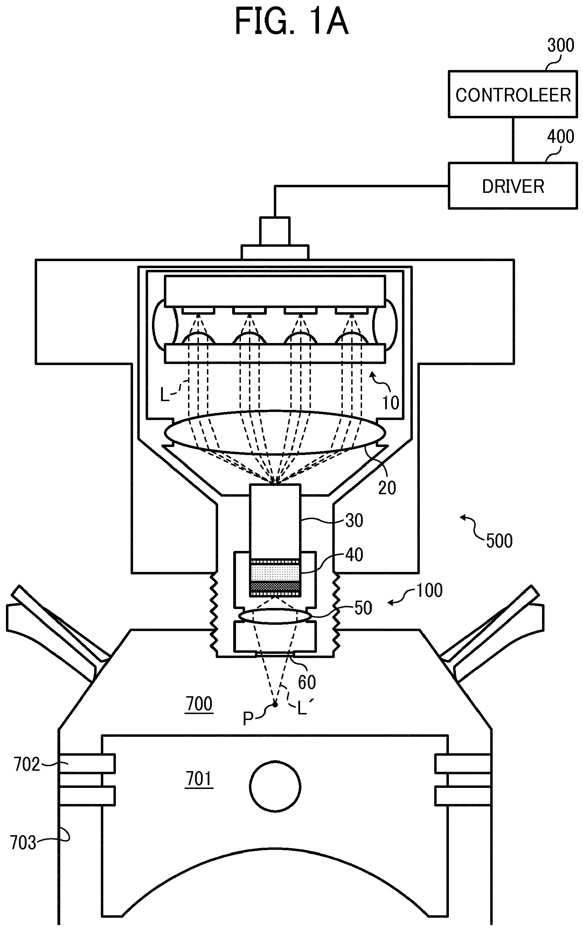

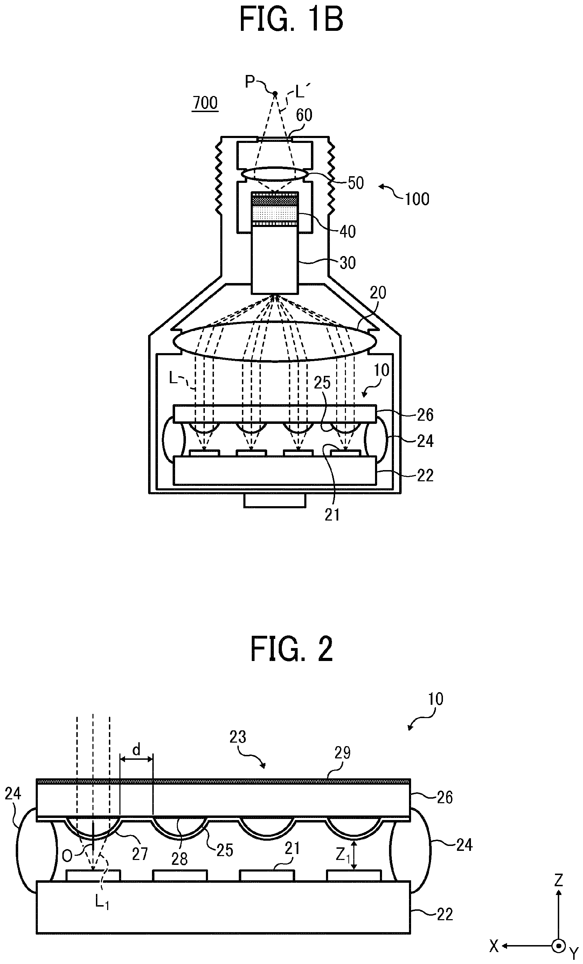

As a first embodiment of the present disclosure, a laser ignition system 500 provided with a laser spark plug 100 that serves as a laser ignition device is illustrated in FIG. 1A and FIG. 1B.

FIG. 1A is a diagram illustrating a schematic configuration of the laser ignition system 500 according to the present embodiment.

FIG. 1B is a magnified view of a laser ignition device according to the present embodiment.

The laser ignition system 500 includes the laser spark plug 100 that performs ignition by collecting and condensing laser beams L towards a combustion chamber 700, a driver 400 that drives the laser spark plug 100, and a controller 300 that controls the driver 400. The laser ignition system 500 also includes a piston 701 that changes the volume of the combustion chamber 700 at regular time intervals due to an up-and-down motion, and a cylinder 703 contacts the piston 701 through a piston ring 702 and together configures the combustion chamber 700. Further, the laser ignition system 500 includes an intake valve and an intake port that supply fuel to the combustion chamber 700, and an exhaust valve and an exhaust port that eject the burned fuel from the combustion chamber 700. The combustion chamber 700 is, for example, a combustion chamber of an internal combustion engine. Note that the description of known structure or configuration of internal combustion engines are omitted.

As illustrated in FIG. 1B, the laser spark plug 100 includes a laser-beam source unit 10 that serves as a light source unit to emit laser beams L, a condensing optical system 20 that collects and condenses the laser beams L emitted from the laser-beam source unit 10, an optical transmission path 30, and an optical amplifier 40. The laser spark plug 100 also includes a condenser lens 50 that collects and condenses the laser beams L amplified by the optical amplifier 40 at a focal point P in the combustion chamber 700, and an exit window 60 arranged between the condenser lens 50 and the combustion chamber 700. The laser spark plug 100 according to the present embodiment serves as a light source module provided with an optical system that collects and condenses the laser beams L emitted from the light source at the focal point P.

The driver 400 in the present embodiment is a laser diode (LD) driver that drives the laser-beam source unit 10. The driver 400 drives the laser-beam source unit 10 according to instructions from the controller 300 to emit the laser beams L.

FIG. 2 is a plan view of the laser-beam source unit 10 illustrated in FIG. 1A and FIG. 1B, according to the present embodiment.

As illustrated in FIG. 2, the laser-beam source unit 10 includes a plurality of light emitters 21 as a single element that emit laser beams L in the Z direction, and a laser substrate portion 22, which serves as an element substrate portion, on which the multiple light emitters 21 are integrally aligned and disposed in a planar fashion. The laser substrate portion 22 and the light emitters 21 are integrally molded, and together configure a vertical-cavity surface-emitting laser (VCSEL) element, i.e., a surface-emitting laser element, to serves as a light source.

The laser-beam source unit 10 also includes a lens array 23 disposed so as to face the laser substrate portion 22, and the lens array 23 is bound to the laser substrate portion 22 by fixed portions 24. In other words, the laser-beam source unit 10 in the present embodiment is a light source unit including a surface-emitting laser element and a micro lens array. In the following description, the direction in which the laser beams L are emitted is referred to as Z-direction. Moreover, among the directions orthogonal to the Z-direction, the direction orthogonal to the view of FIG. 2 is referred to as Y-direction, and the direction orthogonal to both the Z-direction and Y-directional is referred to as X-direction.

The lens array 23 includes a plurality of lenses 25 arranged so as to face the respective light emitters 21 on a one-by-one basis, and a lens substrate portion 26 disposed to support the lenses 25. The lens array 23 also includes a first antireflection layer 27 formed on an outermost surface layer, i.e., the surface on the -Z side, of the lenses 25, a second antireflection layer 28 formed between the lenses 25 and the lens substrate portion 26, and a third antireflection layer 29 formed on a surface of the lens substrate portion 26 on the light exiting side.

In the present embodiment, a configuration including the first antireflection layer 27, the second antireflection layer 28, and the third antireflection layer 29 is described. However, no limitation is intended thereby. It is not necessary to include all the three layers of the first antireflection layer 27, the second antireflection layer 28, and the third antireflection layer 29, and any one of, any two of, or none of the first antireflection layer 27, the second antireflection layer 28, and the third antireflection layer 29 may be formed.

The light emitters 21 are integrally molded on a +Z-side surface of the laser substrate portion 22 made of GaAs of φ9, and together configure a vertical cavity-surface emitting laser (VCSEL). The laser substrate portion 22 is a GaAs substrate whose coefficient of linear expansion at the absolute temperature of 300K (about 27° Celsius) is $6.86 \times 10^{-6}$/K.

The lens substrate portion 26 is a lens substrate made of glass that allows the laser beams L pass through. It is desired that the average coefficient of linear expansion of the lens substrate portion 26 in the ambient temperature, at the operating temperatures of -30° Celsius to +70° Celsius where the laser-beam source unit 10 is used, match the coefficient of linear expansion of the laser substrate portion 22. In other words, it is desired that the average coefficient of linear expansion of the lens substrate portion 26 fall within a range from 6.8 to $6.9 \times 10^{-6}$/K. A glass material that satisfies such a coefficient of linear expansion, includes, for example, N-BAF52 (by SCHOTT), S-BAH11, S-BAH32, S-NBH53 (by OHARA), BACD18, TAFD30, TAFD33, TAFD37, LAC7, and M-LAC130 (by HOYA).

The lenses 25 in the present embodiment are convex in the -Z-direction and made of synthetic quartz glass having positive powers. Such a synthetic quartz glass has a coefficient of linear expansion of $0.47 \times 10^{-6}$/K. Apart from the synthetic quartz glass, the material of the lenses 25 may be a glass material such as Neoceram N-0 (by Nippon Electric Glass Co., Ltd.) and TEMPAX Float (registered trademark, by SCHOTT). Note also that the TEMPAX Float is a borosilicate glass. The lenses 25 that are adjacent to each other are disposed at intervals of infinitesimal distance d. In other words, the multiple lenses 25 are separate from each other.

Each one of the lenses 25 is disposed such that the optical axis "O" of the relevant one of the lenses 25 matches the central optical axis of the laser beam that the facing one of the light emitters 21 emits. In FIG. 2, such a laser beam in particular is referred to as laser beams $L_1$. The substrate-to-substrate spacing $z_1$ is adjusted such that the focal points of the lenses 25 match the light-emitting points of the light emitters 21. In other words, the lenses 25 face the light source and are arranged in line with the optical axes of the light source. Due to this configuration the lens array 23 can emit the laser beam $L_1$, which is emitted from the facing light emitter 21, as a collimated beam.

The fixed portion 24 is made from an ultraviolet (UV)-curable resin and binds the lens substrate portion 26 and the laser substrate portion 22.

The first antireflection layer 27 is an antireflection coating that reduces the surface reflection light when the laser beams L enter the lenses 25. Note also that the first antireflection layer 27 may be a multilayer film where a plurality of layers are overlaid on top of each other. Such an antireflection coating may be, for example, a dielectric multilayer, and a thin layer of magnesium fluoride ($MgF_2$).

Effects of such an antireflection coating are further described in detail. On the interface between two kinds of substances with two different refractive indexes, some of transmitting light is reflected. As known in the art, as the difference in refractive index between two kinds of substances is greater, the amount of reflection light tends to increase. When the laser beams L that are incident on the lenses 25 are reflected, as a matter of course, the amount of light that passes through the lens array 23 decreases according to the amount of reflection, and the power consumption may increase and the life of the light emitters 21 may decrease. Moreover, when the reflected light enters the light emitters 21 again, the laser oscillation becomes unstable, and the output from the laser-beam source unit 10 also becomes unstable.

In order to handle such a situation, in the present embodiment, the first antireflection layer 27 having an approximately intermediate refractive index between the refractive index (about 1.0) of air and the refractive index (about 1.5) of synthetic quartz glass that makes up the lenses 25 is formed on the surface the lenses 25 on the -Z side. Note that refractive index of the synthetic quartz glass depends on the wavelength. Due to this configuration, in the lens array 23, the incident laser beams L are prevented from reflecting back to the light emitters 21, and the utilization efficiency of light improves. In the present embodiment, the refractive index of the first antireflection layer 27 is adjusted to control the reflection light. However, for example, the materials of the first antireflection layer 27 are not limited for the purpose of controlling the reflection light.

The second antireflection layer 28 is an antireflection coating that reduces the reflection light on the interface between the lenses 25 and the lens array 23. It is desired that the second antireflection layer 28 be made from aluminum oxide ($Al_2O_3$) having an approximately intermediate refractive index between the material of the lenses 25 and the material of the lens substrate portion 26. However, the second antireflection layer 28 may be made from the materials cited for the first antireflection layer 27 as above.

The film formation methods for the first antireflection layer 27 and the second antireflection layer 28 are not limited to particular methods. However, for example, an electron-beam vapor deposition may be used. Due to the configuration described above, in the lens array 23, the incident laser beams L are further prevented from reflecting back to the light emitters 21.

As the configuration of the third antireflection layer 29 is similar to those of the first antireflection layer 27 and the second antireflection layer 28, its description is omitted.

The condensing optical system 20 is a condenser lens that collects and condenses the laser beams L emitted from the laser-beam source unit 10 towards the optical transmission path 30. The condensing optical system 20 is satisfactory as long as it includes at least one lens, and the configuration of the condensing optical system 20 is not limited.

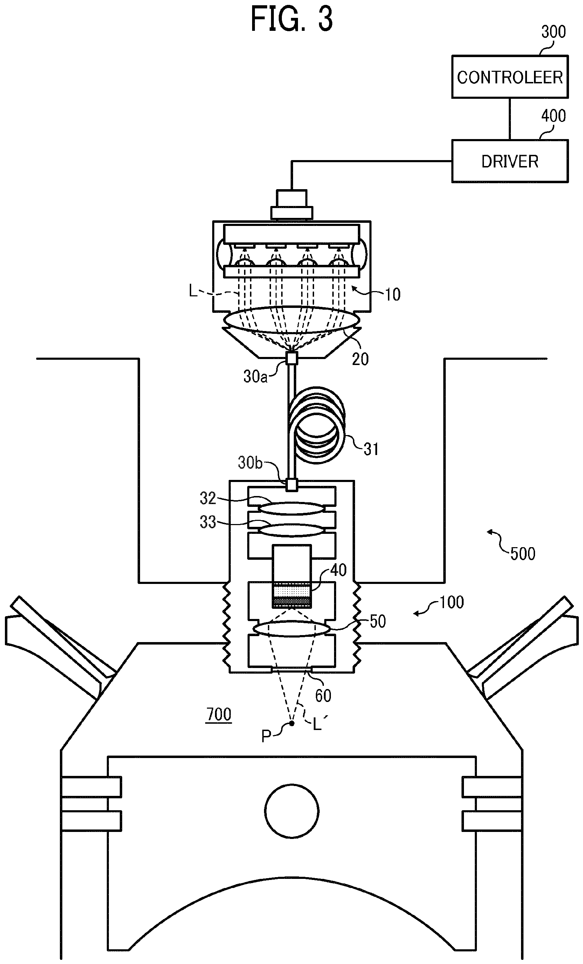

FIG. 3 is a plan view of the optical transmission path 30 illustrated in FIG. 1, according to the present embodiment.

As illustrated in FIG. 3, the optical transmission path 30 includes an optical fiber 31 that transmits the light incident on an entering port 30a to an exit port 30b, and a collimator lens 32 that collimates the light exiting from the exit port 30b to parallel light. The optical transmission path 30 also includes a condenser lens 33 that collects and condenses the laser beams L collimated by the collimator lens 32 towards the optical amplifier 40. In the present embodiment, the optical transmission path 30 is an optical system composed of a combination of an optical fiber, a collimator lens, and a condenser lens. However, the optical transmission path 30 is satisfactory as long as it can guide the laser beams L emitted from the condensing optical system 20 so as to enter the optical amplifier 40.

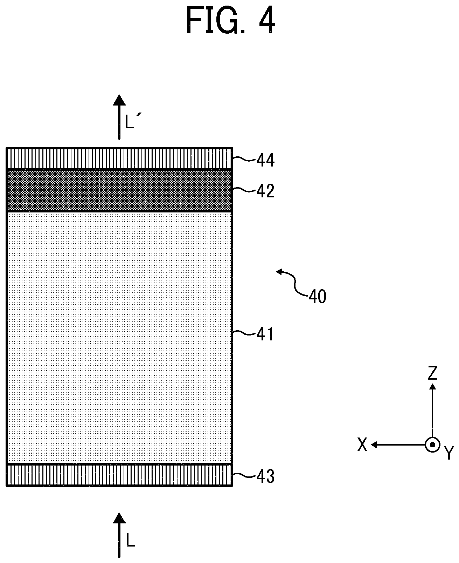

FIG. 4 is a plan view of the optical amplifier 40 illustrated in FIG. 1, according to the present embodiment.

The optical amplifier 40 is a Q-switched laser resonator where a laser medium 41 and a saturable absorber 42 integrated inside serve as a Q-switched laser oscillator due to a laser beam L entering as pump light and a high-gain pulsed laser L' exits. As illustrated in FIG. 4, the optical amplifier 40 includes the laser medium 41, the saturable absorber 42, a first dielectric multilayer 43 formed on an end on the -Z side, and a second dielectric multilayer 44 formed on an end on the +Z side. The optical amplifier 40 is a composite crystal in which the laser medium 41 and the saturable absorber 42 are integrally bonded together. The laser medium 41 is placed on the light entering side, and the saturable absorber 42 is placed on the light exiting side. The end on the light entering side, i.e., on the -Z side in FIG. 4, of the laser medium 41 and the end on the light exiting side, i.e., on the +Z side in FIG. 4, of the saturable absorber 42 are optically polished, and the first dielectric multilayer 43 and the second dielectric multilayer 44 are further formed, respectively. Due to this configuration, the two ends of the optical amplifier 40 on the +Z side and the -Z side serve as mirror surfaces that reflect the internally pumped pulsed laser L'.

The laser medium 41 is an Nd: YAG crystal where Nd is doped by 1.1%. The saturable absorber 42 is a Cr: YAG crystal, where the initial transmittance is about 30%. The first dielectric multilayer 43 is a coating that indicates high transmittance to the wavelength of the laser beam L and indicates high reflectance to the wavelength of 1064 nanometers (nm) of the pulsed laser L' emitted from the laser medium 41. The second dielectric multilayer 44 is a coating that indicates reflectance of 30 to 80% to the wavelength of 1064 nm of the pulsed laser L'. Due to a configuration as described above where two different dielectric multilayers are formed on both ends on the +Z side and the -Z side, the optical amplifier 40 can reflect the internally pumped pulsed laser L' more efficiently.

As the laser beam L enters the laser medium 41, the laser beam L is pumped and produce an inverted state. The saturable absorber 42 serves as a passive Q-switch. In other words, when the light quantity of pulsed laser L' is less than a prescribed value, the saturable absorber 42 serves as an absorber, and when the light quantity of pulsed laser L' is equal to or greater than a prescribed value, the saturable absorber 42 transmits the pulsed laser L' as an exiting light. Due to the configuration described above, the laser beam L that enters the optical amplifier 40 is resonated, and is exited as an amplified pulsed laser L'.

The pulsed laser L' that is exited through the optical amplifier 40 is collected and condensed by the condenser lens 50 towards an irradiation point P, and ignites the mixture of gases inside the combustion chamber 700.

In the laser spark plug 100, an improved output of the light emitters 21 is desired to ignite the mixture of gases more efficiently. However, an improved output of the light emitters 21 leads to an increase in the heat produced in the laser-beam source unit 10. As in the present embodiment, the laser spark plug 100 tends to be disposed near the combustion chamber 700 that is an internal combustion engine, and changes in ambient temperature due to external heat is significant.

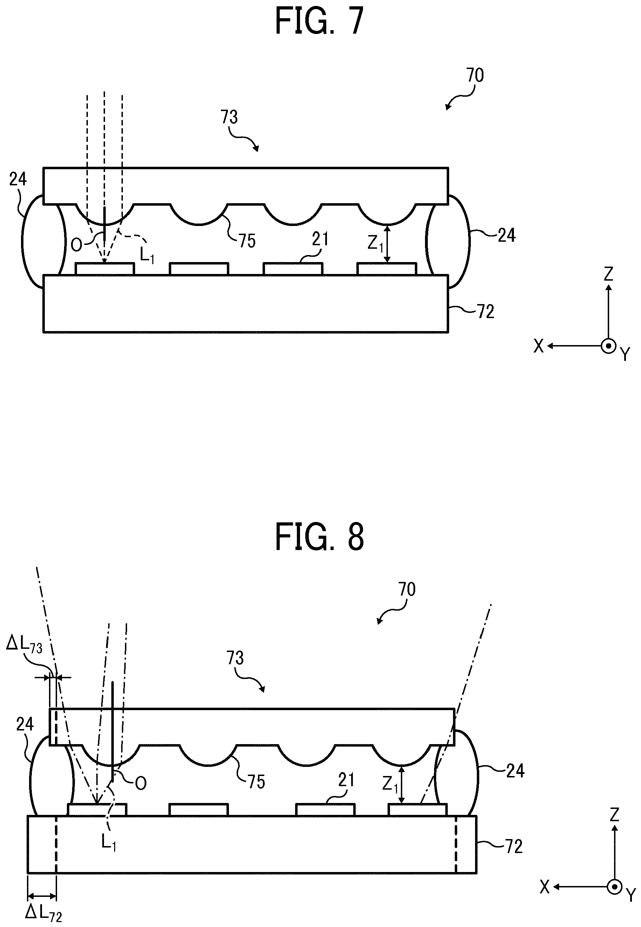

FIG. 7 is a plan view of a microlens unit according to a related art.

FIG. 8 is a plan view of the impact of thermal expansion in the related art illustrated in FIG. 7.

In the related art illustrated in FIG. 7, a lens array 73 and a plurality of lenses 75 are integrally molded in a laser beam source 70. If the laser beam source 70 of such a configuration as above is used under high ambient temperature conditions, as illustrated in FIG. 8, due to a difference in coefficient of linear expansion between the lens array 73 and a laser substrate 72, there is some concern that the optical axis O of the relevant one of the lenses 75 may be misaligned from the central optical axis of laser beam $L_1$. In order to provide more concrete description, it is assumed that the size and shape of the laser substrate 72, which is a GaAs substrate, is a circle with $\varphi$9 millimeters (mm) and the ambient temperature has changed from 20° Celsius to 50° Celsius, the amount of misalignment $\Delta L_{72}$ on the periphery of the laser substrate 72 on the +X side is measured. For the purpose of simplification, in the following description, when an amount of misalignment $\Delta L$ of a particular component is indicated, the reference sign of such a component is given as a numeral subscript.

[Formula 1]

$$\Delta L_{72} = \alpha L \Delta T = 6.86 \times 10^{-6}(/K) \times 4.5(mm) \times 30(K) = 0.9(\mu m)$$

In a similar manner, as the synthetic quartz glass has a coefficient of linear expansion of $4 \times 10^{-7}(/K)$, the amount of misalignment $\Delta L_{73}$ of the lens array 73 due to thermal expansion is expressed in Formula 2 given below.

[Formula 2]

$$\Delta L_{73} = \alpha L \Delta T = 4 \times 10^{-7}(/K) \times 4.5(mm) \times 30(K) = 0.054(\mu m)$$

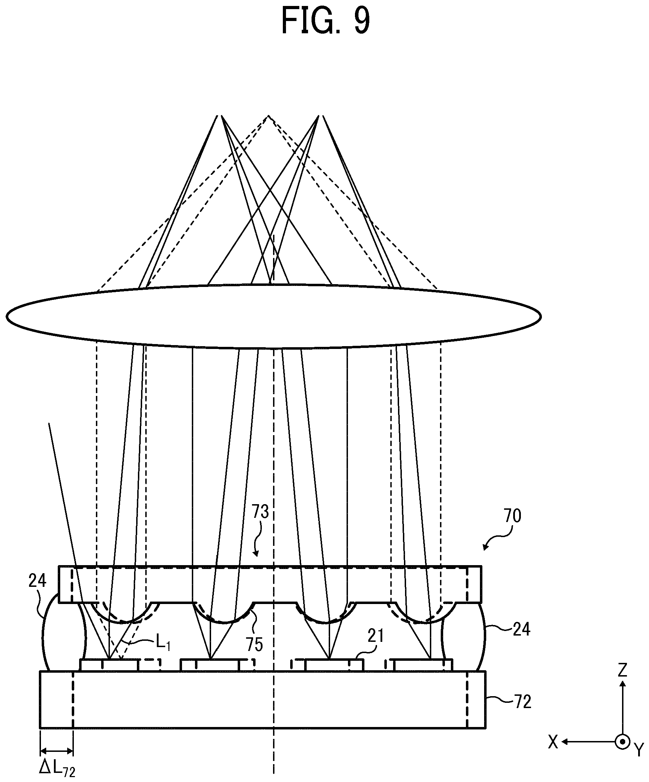

FIG. 9 is a diagram illustrating the displacement of focal points due to the thermal expansion illustrated in FIG. 8.

As described above, when the ambient temperature increases by 30° Celsius, the laser substrate 72 becomes misaligned from the lens array 73 by about 0.9 micrometers ($\mu m$) on the periphery. When the optical axis of the relevant one of the lenses 75 becomes misaligned from the central optical axis of laser beam $L_1$ due to the above misalignment, as schematically illustrated in FIG. 8 by alternate long and short dashed lines, the collimation is no longer achieved by the lenses 75, and some of the laser beams L that are to be collected and condensed towards the focal point of the condensing optical system 20 may be dispersed.

In FIG. 9, such misalignment in focal point is exaggerated for purposes of illustration by solid lines and broken lines. As understood from the above description, due to the misalignment between the optical axis of a lens and the light-emitting point, it becomes difficult to collect and condense the laser beams L towards the focal point of the condensing optical system 20. In other words, the utilization efficiency of the laser beams L that are emitted from laser beam source 70 deteriorates. Such deterioration in utilization efficiency leads to a reduction in the light quantity of pump light at the optical amplifier 40, and it becomes difficult to radiate the pulsed laser L' with stability.

If the material of the lens array 73 is chosen in accordance with the coefficient of linear expansion of the laser substrate 72, the selectable refractive index of the lens array 73 is limited, and such a limitation significantly restricts the design of the laser beam source 70. Moreover, most of the glass materials with a good refractive index that are used for optical usage have poor processability for dry etching, and it is difficult to make microlenses with a high degree of precision.

In order to handle such a situation, in the present embodiment, the lens array 23 holds the lenses 25, and has the lens substrate portion 26 whose coefficient of linear expansion is approximately same as the laser substrate portion 22. Note that the expression "coefficient of linear expansion is approximately same" indicates that the difference between an amount of misalignment $\Delta L_{23}$ and an amount of misalignment $\Delta_{22}$ caused by thermal expansion, within a range of ambient temperature where the lens array 23 is used, is sufficiently small compared with the effective diameter of the lenses 25. Due to the configuration described above, the misalignment between the optical axes O of the lenses 25 and the central optical axes of the light emitters 21 is reduced, and the collimation of the laser beams L is maintained. Due to this configuration, even under high ambient temperature conditions, the utilization efficiency of light can be prevented from decreasing in the laser-beam source unit 10, and the precision can also be prevented from decreasing.

In order to provide more concrete description, [Formula 3] is given below, where $\alpha$ lens denotes the coefficient of linear expansion of the lens substrate portion 26, $\alpha_{base}$ denotes the coefficient of linear expansion of the laser substrate portion 22, L denotes the distance between the center C of the lens substrate portion 26 and the lens 25 furthest from the center C, $\Delta T$ denotes the temperature differential in ambient temperature, and $\Delta d$ denotes the tolerance of the misalignment of the optical axes of the lenses 25. For example, when the laser-beam source unit 10 is designed such that L=4.5 [mm], $\Delta T$=30 [K], and $\Delta d$=0.1 [$\mu m$], $\alpha_{base}$=6.86$\times$ 10$^{-6}$[/K] if the laser substrate portion 22 is a GaAs substrate, and thus it is desired that $\alpha_{lens}$ fall within the range as follows.

$$6.12 \leq \alpha_{lens} \leq 7.60 [\times 10^{-6}/K]$$

The coefficient of linear expansion $\alpha_{lens}$ can take on a wider range of values as the tolerance $\Delta d$ of the misalignment of the optical axis is greater. When $\Delta d$=0.5 $\mu m$, $3.16 \leq \alpha_{lens} \leq 10.56 [\times 10^{-6}/K]$. When $\Delta d$=0.8 $\mu m$, $0.93 \leq \alpha_{lens} \leq 12.78 [\times 10^{-60}/K]$.

[Formula 3]

$$|(\alpha_{base} - \alpha_{lens})L\Delta T| \leq \Delta d$$

Moreover, the coefficient of linear expansion $\alpha_{lens}$ takes on a narrower range of values as the temperature differential $\Delta T$ of ambient temperature increases. When $\Delta T$=50[K], $6.42 \leq \alpha_{lens} \leq 7.30 [\times 10^{-6}/K]$. In a similar manner, when $\Delta T$=100[K], $6.64 \leq \alpha_{lens} \leq 7.08 [\times 10^{-6}/K]$. The distance L depends on the size of the VCSEL element as follows. When L=9 mm, $6.49 \leq \alpha_{lens} \leq 7.23 [\times 10^{-6}/K]$. When L=18 mm, $6.67 \leq \alpha_{lens} \leq 7.05 [\times 10^{-6}/K]$. As described above for example, as the size of the laser substrate portion 22 is greater, the selectable width of the coefficient of linear expansion becomes narrower.

When the GaAs substrate is removed from a laser substrate and the resultant laser substrate is stuck onto a ceramic substrate or metal substrate with high thermal conductivity so as to serve as the laser substrate portion 22, the coefficient of linear expansion of such a metal or ceramic may be used as $\alpha_{base}$ to determine the lens substrate portion 26. For example, when the resultant laser substrate is stuck onto an aluminum nitride substrate, $\alpha_{base}$=4.6[$\times 10^{-6}/K$]. When the resultant laser substrate is stuck onto a copper substrate, $\alpha_{base}$=16.8[$\times 10^{-6}/K$]. In such cases, when the laser-beam source unit 10 is designed such that L=4.5 [mm], $\Delta T$=30[K], and $\Delta d$=0.1 [$\mu m$] as described above, the range of $\alpha_{lens}$ is determined as below. When $\alpha_{base}$=4.6[$\times 10^{-6}K$], it is desired that $\alpha_{lens}$ fall within the range as follows.

$$3.86 \leq \alpha_{lens} \leq 5.34 [\times 10^{-6}/K]$$

In a similar manner , when $\alpha_{base}$=16.8[$\times 10^{-6}/K$], it is desired that $\alpha_{lens}$ fall within the range as follows.

$$16.1 \leq \alpha_{lens} \leq 17.5 [\times 10^{-6}/K]$$

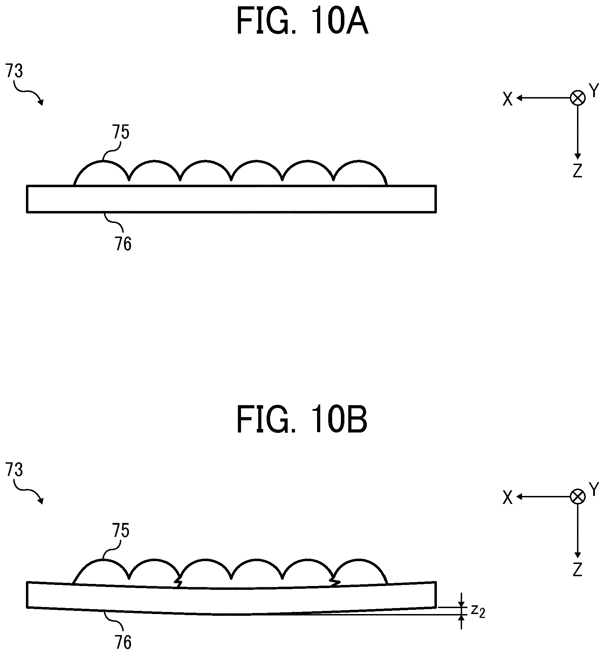

FIG. 10A and FIG. 10B are schematic diagrams of micro lenses according to a modification.

As illustrated in FIG. 10A and FIG. 10B, when the lens array 73 includes the multiple lenses 75 and a lens substrate portion 76 and the multiple lenses 75 are arranged so as to be adjacent to each other, there is some concern that the lens array 73 may be curved or cracked due to a large difference in coefficient of linear expansion between the lenses 75 and the lens substrate portion 76.

In order to prevent such a failure, when an amount of deformation z2 caused due to changes in ambient temperature and a difference in coefficient of linear expansion is significantly large with reference to the thickness of the lens substrate portion 76, it is desired that the adjacent lenses 75 be arranged so as to be separate from each other by infinitesimal distance d.

The portions that separate the multiple lenses 25 from each other by the infinitesimal distance d in the lens substrate portion 26 are referred to as a boundary area. In other words, the boundary area is an area among points of inflection R of the multiple lenses 25 that are adjacent to each other, and is an area with no curvature in the lens array 23. By arranging such a boundary area, the displacement of the lens array 23 is not dependent upon the material of the lenses 25, and even under high ambient temperature conditions, the utilization efficiency of light can be prevented from decreasing.

In the present embodiment, the multiple lenses 25 are supported by the lens array 23 in a state where the lenses 25 are separate from each other. Due to this configuration, the amount of displacement of the lens array 23 due to thermal expansion is not dependent upon the material of the lenses 25. Accordingly, the materials for the lenses 25 may be freely selected, and even under high ambient temperature conditions, the utilization efficiency of light can be prevented from decreasing and the precision can also be prevented from decreasing.

In the present embodiment, the lens array 23 has the lens substrate portion 26 whose coefficient of linear expansion is different from the coefficient of linear expansion of the lenses 25. Due to this configuration, the materials for the lenses 25 may be freely selected, and even under high ambient temperature conditions, the utilization efficiency of light can be prevented from decreasing.

In the present embodiment, the lens array 23 also includes the first antireflection layer 27 formed on a top surface of the lenses 25 on the -Z side. Due to this configuration, the incident laser beams L are prevented from reflecting back to the light emitters 21, and the utilization efficiency of light improves. In the present embodiment, the second antireflection layer 28 is formed between the lenses 25 and the lens substrate portion 26. Due to this configuration, the incident laser beams L are further prevented from reflecting back to the light emitters 21, and the utilization efficiency of light improves.

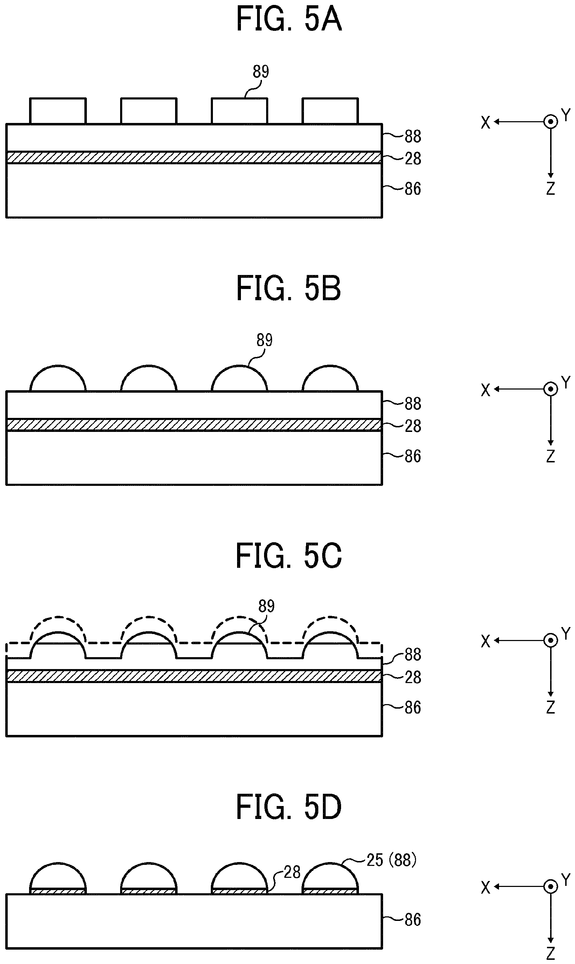

FIG. 5A, FIG. 5B, FIG. 5C, and FIG. 5D are schematic diagrams of the process of forming microlenses, according to the present embodiment.

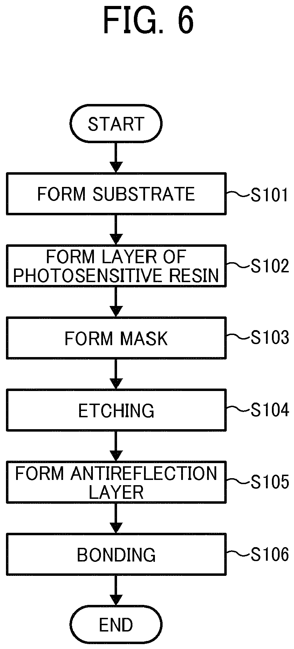

FIG. 6 is a flowchart of a method of manufacturing microlenses, according to the present embodiment.

A method of manufacturing the lens array 23 is described. Firstly, as illustrated in FIG. 5A, the second antireflection layer 28 and a synthetic quartz glass 88 are layered on a substrate 86 made of N-BAF52 (step S101 in FIG. 6). Note that the lens substrate portion 26 is also made of N-BAF52. Then, the photosensitive resin 89 is formed on surface of the synthetic quartz glass 88 in circular or polygon patterns using photolithography (step S102). Then, the photosensitive resin 89 that is formed on the surface of the synthetic quartz glass 88 is heated, and as illustrated in FIG. 5B, the photosensitive resin 89 starts deforming by heat. Then, due to the surface tension, hemispheres are formed, or convex curved surfaces are formed on the -Z side (step S103). The step S103 is a mask forming step where mask patterns are formed by the photosensitive resin 89. In the mask forming step, microlens patterns are formed the surfaces of the synthetic quartz glass 88 by the photosensitive resin 89 simulating the shape of the lenses 25 that will be produced later. Note also that in the mask forming step, it is desired that the height of the lens patterns formed by the photosensitive resin 89 from the bottom end to the top end, i.e., the thickness of the photosensitive resin 89, be equivalent to the thickness of the synthetic quartz glass 88.

Next, etching such as electron cyclotron resonance (ECR) plasma etching or reactive ion etching (RIE) is performed using etching gas that is a mixture of oxygen gas and chlorofluorocarbon (CFC) gas (step S104). Note that the oxygen gas etches photosensitive resin and the CFC gas etches synthetic quartz glass. In the etching step of the step S104, as illustrated in FIG. 5C, the photosensitive resin 89 and the synthetic quartz glass 88 are etched such that the shape of the photosensitive resin 89 is transferred onto the synthetic quartz glass 88.

The etching step proceeds until the photosensitive resin 89 ceases, and the shape of the photosensitive resin 89 is transferred onto the synthetic quartz glass 88 and as illustrated in FIG. 5D, the lenses 25 are formed. In the present embodiment, the thickness of the photosensitive resin 89 is equivalent to the thickness of the synthetic quartz glass 88 and the etching rate of the photosensitive resin 89 is equivalent to the etching rate of the synthetic quartz glass 88. Accordingly, when the photosensitive resin 89 ceases, the synthetic quartz glass 88 form the lenses 25 that are separate from each other. The second antireflection layer 28 may be formed so as to fill the gap among the lenses 25. If the material of the substrate 86 is selected so as not to be etched or not easily etched by the etching gas, even when the thickness of the photosensitive resin 89 is different from the thickness of the synthetic quartz glass 88, the lenses 25 that are separate from each other are formed. In a similar manner, for example, the mixing ratio of the etching gas may be changed to control the etching rate according to the thickness.

After the etching is complete and the lens array 23 including the lenses 25 formed by the synthetic quartz glass 88 and the lens substrate portion 26 formed by the substrate 86 is formed, for example, a vacuum forming method is used to form the first antireflection layer 27 where appropriate (step S105).

The lens array 23 is attached to the laser substrate portion 22 via the fixed portion 24 such that the lenses 25 face the light emitters 21 (step S106). The step S106 is a bonding step where the lens array 23 and the laser substrate portion 22 are bound together and fixed. In the present embodiment, the fixed portion 24 is made from UV-curable resin, and has flexibility to some degree after fixation. In the present embodiment, the fixed portion 24 is made from UV-curable resin. However, the fixed portion 24 in the step S106 may be solder, and such solder may be heated to 300° Celsius and molten and then cooled and fixed. In the configuration of the related art as described above with reference to FIG. 8, damage may be caused due to the thermal expansion or thermal stress of the lens array 23 by heating and cooling in the cooling step. However, the present embodiment, the lens array 23 holds the lenses 25, and is provided with the lens substrate portion 26 whose coefficient of linear expansion is approximately same as the laser substrate portion 22. Accordingly, a difference in amount of thermal deformation is small, and damage in the bonding step due to thermal stress in heating can be prevented.

In the present embodiment, the laser spark plug 100 includes the optical amplifier 40 that amplifies the laser beams L emitted from the light emitters 21, and the condensing optical system 20 that collects and condenses the laser beams L to the port of the optical amplifier 40. Due to this configuration, even under high ambient temperature conditions, the utilization efficiency of light can be prevented from decreasing.

In the present embodiment, three antireflection layers are provided. However, no such antireflection layer may be provided, or any desired number of antireflection layers may be provided.

Numerous additional modifications and variations are possible in light of the above teachings. It is therefore to be understood that within the scope of the appended claims, the disclosure of the present invention may be practiced otherwise than as specifically described herein. For example, elements and/or features of different illustrative embodiments may be combined with each other and/or substituted for each other within the scope of this disclosure and appended claims.

**Claims**

1.  A light source unit (10) comprising:

    a lens array (23) including a plurality of two-dimensionally disposed lenses (25) and a lens substrate portion (26) that supports the plurality of lenses (25), the lens substrate portion (26) having a first coefficient of linear expansion; and
    an element substrate portion (22) that supports a plurality of light emitters (21), the element substrate portion having a second coefficient of linear expansion,
    wherein the first coefficient of linear expansion is approximately same as the second coefficient of linear expansion of the element substrate portion (22).

2.  The light source unit (10) according to claim 1, wherein the plurality of lenses (25) have a third coefficient of linear expansion different from the first coefficient of linear expansion of the lens substrate portion (26).

3.  The light source unit (10) according to claim 1 or 2, wherein
    the plurality of lenses (25) have a boundary area to be separate from each other by infinitesimal distance (d), and are supported by the lens substrate portion (26).

4.  The light source unit (10) according to any one of claims 1 to 3, wherein the plurality of light emitters (21) and the plurality of lenses (25) face each other on a one-by-one basis.

5.  The light source unit (10) according to any one of claims 1 to 4, wherein the plurality of lenses (25) are disposed so as to be in line with optical axes of the plurality of light emitters (21).

6.  The light source unit (10) according to any one of claims 1 to 5, wherein a product of a difference between the first coefficient of linear expansion of the lens substrate portion (26) and the second coefficient of linear expansion of the element substrate portion (22), a distance (L) between a center (C) of the lens array (23) and a center of one of the plurality of lenses (25) furthest from the center (C), and a temperature differential ($\Delta$T) of ambient temperature is equal to or smaller than tolerance ($\Delta$d) of optical axis misalignment.

7.  The light source unit (10) according to any one of claims 1 to 6, further comprising a first antireflection coating (27) formed on top surfaces of the plurality of lenses (25).

8.  The light source unit (10) according to any one of claims 1 to 7, further comprising a second antireflection coating (28) formed between the plurality of lenses (25) and the lens substrate portion (26).

9.  The light source unit (10) according to any one of claims 1 to 8, further comprising:

    a light source (21, 22) including a plurality of light emitters (21) as a single element, disposed to face the plurality of lenses (25), and the element substrate portion (22) on which the single element (21) is integrally molded; and
    a fixed portion (24) configured to fix the lens substrate portion (26) and the element substrate portion (22) together.

10. The light source unit (10) according to any one of claims 1 to 9, wherein the plurality of lenses (25) are convex and face the plurality of light emitters (21).

11. A light source module (100) comprising:

    the light source unit (10) according to claim 9 or 10; and
    a condenser lens (20, 33, 50) configured to collect and condense pump light emitted from the light source unit (10).

12. A laser ignition device (100) comprising:

    the light source module (100) according to claim 11; and
    a laser resonator (40) configured to absorb the pump light emitted from the light source unit (10).

13. The laser ignition device (100) according to claim 12, further comprising an optical transmission path (30) disposed between the light source module (100) and the laser resonator (40) to transmit the pump.

**14.** The laser ignition device (100) according to claim 12 or 13, further comprising a condensing optical system (20) configured to collect and condense the pump light to a port of the laser resonator (40).

# FIG. 1A

# FIG. 1B

# FIG. 2

# FIG. 3

# FIG. 4

L´

44

42

40

41

43

L

Z

X ← ⊙ Y

# FIG. 5A

89

88
28
86

X ←  ⊙ Y
↓ Z

# FIG. 5B

89

88
28
86

X ←  ⊙ Y
↓ Z

# FIG. 5C

89

88
28
86

X ←  ⊙ Y
↓ Z

# FIG. 5D

25 (88)
28
86

X ←  ⊙ Y
↓ Z

# FIG. 6

```
          START
            │
            ▼
   ┌─────────────────┐
   │  FORM SUBSTRATE │  ～S101
   └─────────────────┘
            │
            ▼
   ┌─────────────────┐
   │  FORM LAYER OF  │  ～S102
   │PHOTOSENSITIVE RESIN│
   └─────────────────┘
            │
            ▼
   ┌─────────────────┐
   │    FORM MASK    │  ～S103
   └─────────────────┘
            │
            ▼
   ┌─────────────────┐
   │    ETCHING      │  ～S104
   └─────────────────┘
            │
            ▼
   ┌─────────────────┐
   │ FORM ANTIREFLECTION│  ～S105
   │      LAYER      │
   └─────────────────┘
            │
            ▼
   ┌─────────────────┐
   │    BONDING      │  ～S106
   └─────────────────┘
            │
            ▼
           END
```

# FIG. 7

# FIG. 8

# FIG. 9

# FIG. 10A

73

75

76

X ← ⊗ Y

Z

# FIG. 10B

73

75

76

X ← ⊗ Y

Z

$z_2$

Europäisches
Patentamt

European
Patent Office

Office européen
des brevets

# EUROPEAN SEARCH REPORT

Application Number

EP 17 15 4453

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HOLGER MOENCH ET AL: "VCSEL arrays with integrated optics", SPIE - INTERNATIONAL SOCIETY FOR OPTICAL ENGINEERING. PROCEEDINGS, vol. 8639, 20 February 2013 (2013-02-20), page 86390M, XP55384978, US ISSN: 0277-786X, DOI: 10.1117/12.2000373 ISBN: 978-1-5106-0753-8 | 1,3-11 | INV.<br>H01S5/022<br>H01S5/42<br>F02P23/04<br><br>ADD.<br>H01S3/06<br>H01S3/094<br>H01S3/0941 |
| Y | * pages 86390M-2, paragraph 2 - pages 86390M-9, paragraph 5; figures 1-5,9 * | 12-14 | H01S5/00<br>H01S5/024<br>H01S5/40 |
| X | US 2005/078720 A1 (WALKER HAROLD Y [US] ET AL) 14 April 2005 (2005-04-14) | 1-6,9-11 | |
| Y | * paragraphs [0041] - [0050]; figures 5-7 * | 12-14 | |
| Y | JP 2014 192166 A (NAT INST NATURAL SCIENCES; NIPPON SOKEN; DENSO CORP) 6 October 2014 (2014-10-06) * paragraphs [0029] - [0032], [0035] - [0037]; figures 1-3,6,7 * | 12-14 | |
| Y | WINTNER E ET AL: "Laser plasma ignition: status, perspectives, solutions", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 9065, 28 November 2013 (2013-11-28), pages 90650B-90650B, XP060032353, DOI: 10.1117/12.2053152 ISBN: 978-1-62841-730-2 * pages 90650B-1, paragraph 2 - pages 90650B-6, paragraph 5; figures 1,5,6 * | 12-14 | |

TECHNICAL FIELDS
SEARCHED     (IPC)

H01S
F02P

The present search report has been drawn up for all claims

| Place of search | Date of completion of the search | Examiner |
|---|---|---|
| Munich | 27 June 2017 | Laenen, Robert |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 17 15 4453

This annex lists the patent family members relating to the patent documents cited in the above-mentioned European search report.
The members are as contained in the European Patent Office EDP file on
The European Patent Office is in no way liable for these particulars which are merely given for the purpose of information.

27-06-2017

| Patent document cited in search report | Publication date | Patent family member(s) | Publication date |
|---|---|---|---|
| US 2005078720 A1 | 14-04-2005 | NONE | |
| JP 2014192166 A | 06-10-2014 | JP 2014192166 A<br>WO 2014156544 A1 | 06-10-2014<br>02-10-2014 |

**REFERENCES CITED IN THE DESCRIPTION**

**Patent documents cited in the description**

- JP 2014192166 A

- JP H06194502 A